# EUROPEAN PATENT APPLICATION

(11) **EP 4 012 860 A1**
(43) Date of publication of application: **15.06.2022**
(21) Application number: 20212988.8
(22) Date of filing: 10.12.2020
(51) Int. Cl.: H02G 1/02, G01C 5/06, G01R 31/58, H02G 7/00

(54) **SYSTEM AND METHOD FOR DETERMINING SAG OF WIRE IN OVERHEAD POWER TRANSMISSION LINE**

(71) Applicant: Haltian Oy, 90230 Oulu (FI)
(72) Inventor: Kujala, Pertti, 90230 Oulu (FI); Sarasmo, Marko, 90230 Oulu (FI)
(74) Representative: Kolster Oy Ab

(57) **Abstract**

System (100) and method for determining sag (154) of wire (150; 200) in overhead power transmission line (190) between two adjacent supports (160, 170) is disclosed. A reference sensor apparatus (110) is attached in a location with a known vertical distance in relation to a clamp (162; 202) coupling the wire (150; 200) with one support (160) of the two adjacent supports (160, 170), and includes a barometric pressure sensor (600) configured to measure (704) a reference barometric pressure. One or more target sensor apparatuses (120, 400, 402) are attached to the wire (150; 200) between the two adjacent supports (160, 170), and each includes a barometric pressure sensor (610) configured to measure (708) a target barometric pressure. A server apparatus (140) is caused to determine (722) the sag (154) of the wire (150; 200) based on the reference barometric pressure and the target barometric pressure.

## Description

### FIELD

Various embodiments relate to a system and a method for determining a sag of a wire in an overhead power transmission line between two adjacent supports.

### BACKGROUND

An overhead power transmission line transmits and distributes electrical energy across large distances. Uninsulated electrical cables are suspended by supports such as poles and towers.

A sag is defined as a vertical difference in level between points of two adjacent supports and the lowest point of a wire between the two adjacent supports.

The sag may increase in cold climates during winter due to an accumulation of snow and ice on an external surface of the wire. The sag may also increase in warm climates during summer as the wire is stretched due to the heat. Furthermore, a wind load may increase the sag further due to an additional stretch of a wire.

An excessive sag may damage the wire and, in some cases, even cause a blackout.

The monitoring of the sag in vast overhead power transmission lines is done manually requiring extensive manpower. Electricians travel by foot, by skis, with snowmobiles, with all-terrain vehicles, and even by helicopters.

US 8,184,015 B2 discloses real-time monitoring of overhead power lines using accelerometers to detect mechanical oscillations of a power line cable, with which also a sag may be determined.

US 2020/0225273 A1 discloses a power line sag monitoring device using an ultrasonic sensor to detect a distance to the ground, an accelerometer to detect a change in distance, or a tilt sensor to detect a sag of the power line.

US 2014/0064389 A1 discloses monitoring of power lines using an echo-located hight, or a laser/optical/audio measurement to provide a height off the ground.

### BRIEF DESCRIPTION

According to an aspect, there is provided subject matter of independent claims. Dependent claims define some embodiments.

One or more examples of implementations are set forth in more detail in the accompanying drawings and the description of embodiments.

### LIST OF DRAWINGS

Some embodiments will now be described with reference to the accompanying drawings, in which
FIG. 1, FIG. 2, FIG. 3, FIG. 4, FIG. 5, and FIG. 6 illustrate embodiments of a system for determining a sag of a wire in an overhead power transmission line between two adjacent supports; and
FIG. 7 is a flow chart illustrating embodiments of a method for determining a sag of a wire in an overhead power transmission line between two adjacent supports.

### DESCRIPTION OF EMBODIMENTS

The following embodiments are only examples. Although the specification may refer to "an" embodiment in several locations, this does not necessarily mean that each such reference is to the same embodiment(s), or that the feature only applies to a single embodiment. Single features of different embodiments may also be combined to provide other embodiments. Furthermore, words "comprising" and "including" should be understood as not limiting the described embodiments to consist of only those features that have been mentioned and such embodiments may contain also features/structures that have not been specifically mentioned.

Reference numbers, both in the description of the embodiments and in the claims, serve to illustrate the embodiments with reference to the drawings, without limiting it to these examples only.

The embodiments and features, if any, disclosed in the following description that do not fall under the scope of the independent claims are to be interpreted as examples useful for understanding various embodiments of the invention.

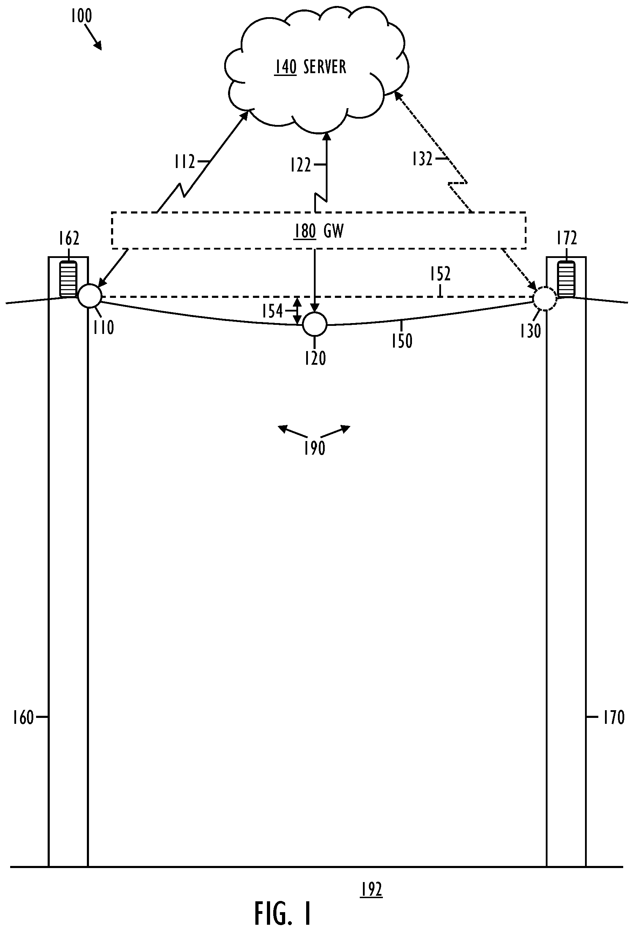

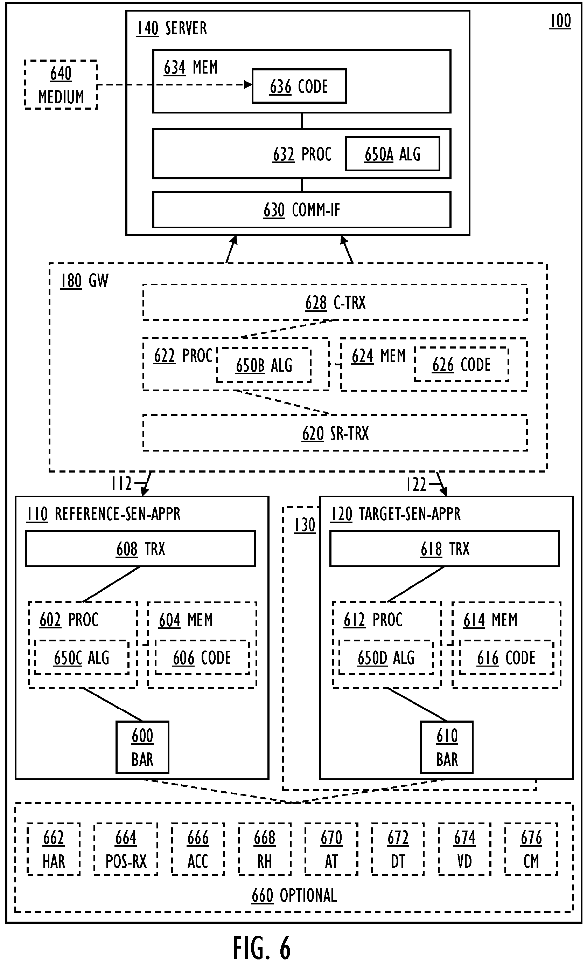

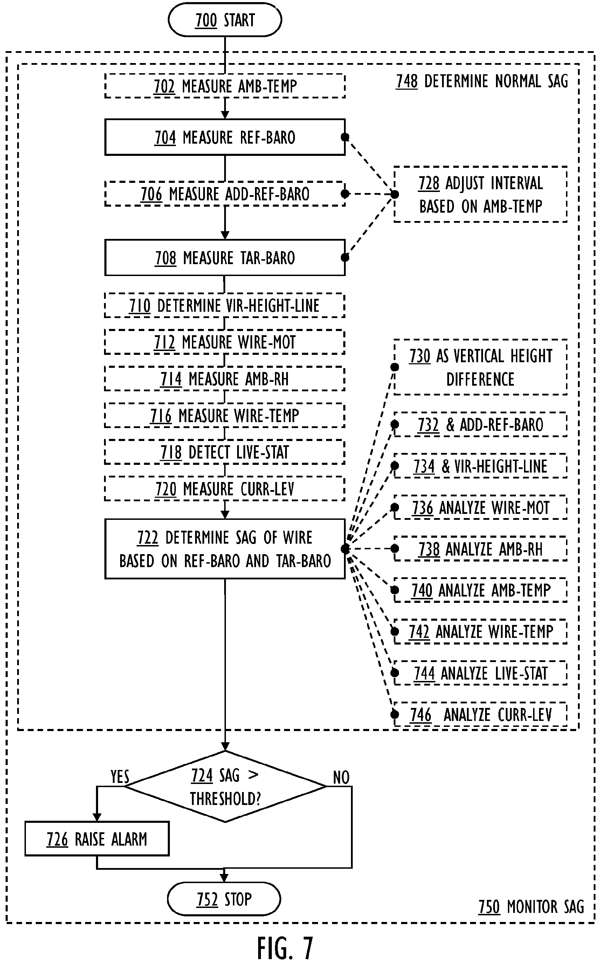

Let us study simultaneously FIG. 1 and FIG. 6, which illustrate embodiments of a system 100 for determining a sag 154 of a wire 150 in an overhead power transmission line 190 above earth 192 between two adjacent supports 160, 170, and FIG. 7, which illustrates embodiments of a method for determining the sag 154. The method may be implemented as a distributed algorithm 650A, 650B, 650C, 650D programmed as computer program code executed by various system actors 110, 120, 130, 140, 180, 400, 402 as will be described in the following.

The system 100 comprises three parts, a reference sensor apparatus 110, one or more target sensor apparatuses 120, and a server apparatus 140.

Note that although FIG. 1 illustrates a single wire 150 between two adjacent poles 160, 170, the embodiments may be applied to more complicated overhead power transmission lines 190 as well.

In FIG. 1 the wire 150 is a power line. The power line 150 may be a high-voltage overhead conductor not covered by insulation. The conductor 150 may be made of aluminium alloy strands, possibly reinforced by steel strands.

As illustrated in FIG. 1, the sag 154 is the vertical difference in level 152 between points of the two adjacent supports 160, 170 and the lowest point of the wire 150 between the two adjacent supports 160, 170.

The sag 150 increases in cold climates during winter due to an accumulation of snow and ice on an external surface of the wire 150, and in warm climates during summer as the wire 150 is stretched due to the heat. A wind load increases the sag 154 further due to an additional stretch of the wire 150.

In FIG. 1, the adjacent supports 160, 170 may be wooden poles, metal poles, or reinforced concrete poles.

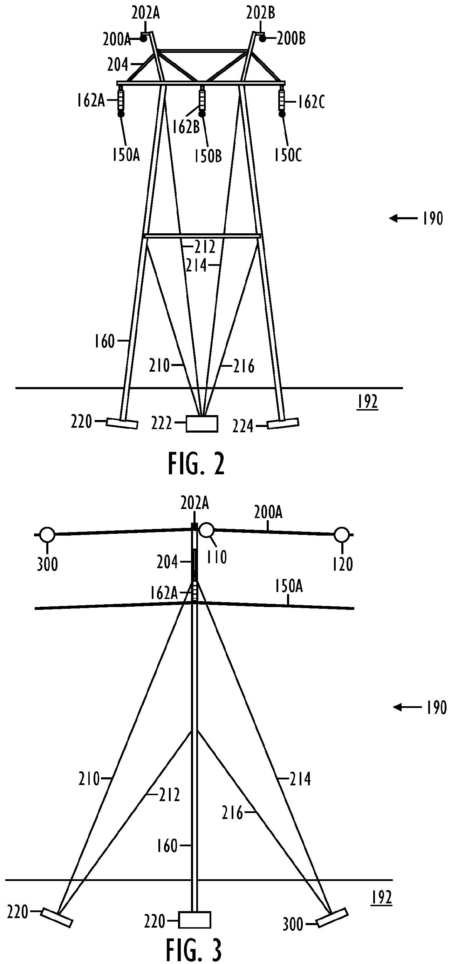

FIG. 2 and FIG. 3 illustrate a front view and a side view to another embodiment, wherein the adjacent supports 160, 170 are lattice metal (aluminium or steel, for example) towers, whose structures may be self-supporting with foundations 220, 224, 300 laid in the ground 192, and possibly augmented by guys 210, 212, 214, 216 fixed to one or more (underground) foundations 222.

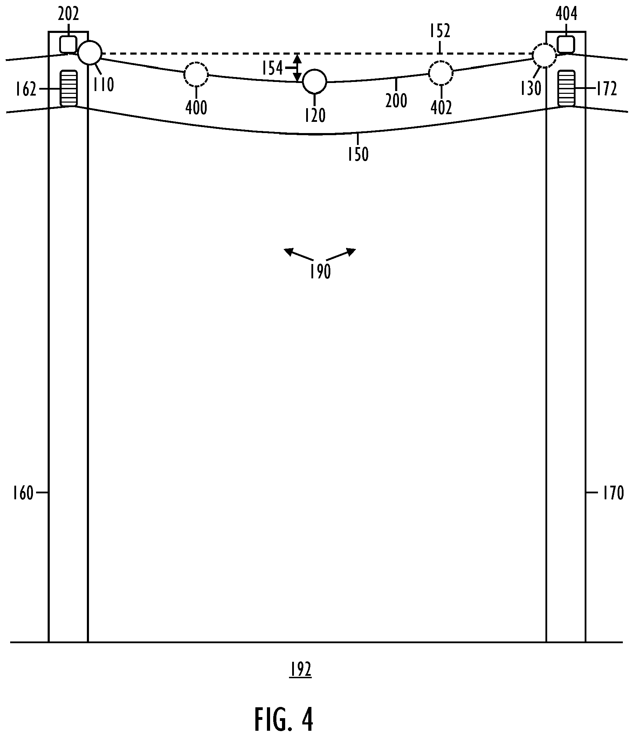

In FIG. 4, the wire 200 is lightning arrester steel wire. The lightning arrester steel wire 200 is located at the top of the supports 160, 170 above the power line 150. The lightning arrester steel wire 200 attracts a lightning and carries a current of the lightning whereby a damage to the power line 150 and its components is prohibited.

As shown in FIG. 2 and FIG. 3, the overhead power transmission line 190 may comprise an upper lattice structure 204 comprising one or more cross-arm beams and (nearly) vertical beams, wire clamps 202A, 202B suspending the topmost two lightning arrester steel wires 200A, 200B, and wire clamps with insulators 162A, 162B, 162C suspending the three power lines 150A, 150B, 150C beneath. The three power lines 150A, 150B, 150C may each carry an alternating current of the same frequency and voltage but with a phase difference between each to implement a three-phase electric power overhead transmission line 190.

The reference sensor apparatus 110 is attached in a location with a known vertical distance in relation to a clamp 162/202 coupling the wire 150/200 with one support 160 of the two adjacent supports 160, 170.

The reference sensor apparatus 110 may be attached to the wire 150/200 next to the clamp 162/202. In this embodiment, the reference sensor apparatus 110 is configured to be attached to the lightning arrester steel wire 200 and/or to the power line 150. The reference sensor apparatus 110 may be encapsulated in a bird ball configured to warn birds of the overhead power transmission line 190. The reference sensor apparatus 110 may be attached to the wire 150/200 in a point, which is as near as possible by the clamp 162/202. In this way, it may be assumed that the reference sensor apparatus 110 is at the same vertical height as the level 152. In an alternative embodiment, the reference sensor apparatus 110 attached to the one support 160 next to the clamp 162/202. Again, if the reference sensor apparatus 110 is attached at the same vertical level as the clamp 162/202, it may be assumed that the reference sensor apparatus 110 is at the same vertical height as the level 152. If the reference sensor apparatus 110 is attached higher or lower than the clamp 162, then the vertical height difference to the level 152 is measured during the installation, stored in the system 100, and taken into account in the calculations.

The reference sensor apparatus 110 comprises a barometric pressure sensor 600 configured to measure 704 a reference barometric pressure. The reference sensor apparatus 110 also comprises a wireless transceiver 608 configured to transmit 112 the reference barometric pressure to the server apparatus 140.

The one or more target sensor apparatuses 120, 400, 402 are attached to the wire 150/200 between the two adjacent supports 160, 170. The one or more target sensor apparatuses 120, 400, 402 are configured to be attached to the lightning arrester steel wire 200 and/or to the power line 150. In an embodiment, the one or more target sensor apparatuses 120, 400, 402 are encapsulated in one or more bird balls configured to warn birds of the overhead power transmission line 190.

The use of bird balls to accommodate the electronics of the sensor apparatuses 110, 120, 400, 402 may provide both the casing to protect against dust, moisture and impacts and also the attachment mechanism to the wire 150/200. As the bird ball may be of a visible colour such as white or orange, they are also easily spotted and observed by the installation/service personnel.

In FIG. 1 there is only one target sensor apparatus 120 between the two adjacent supports 160, 170, and the single target sensor apparatus 120 is attached to a middle point in the wire 150 between the two adjacent supports 160, 170 as this is also the lowest point of the wire 150 between the two adjacent supports 160, 170 defining the sag 154. In FIG. 4 there is a plurality of target sensor apparatuses 120, 400, 402 attached to known points in the wire 200 between the two adjacent supports 160, 170. The known points may be defined as predetermined distances between adjacent target sensor apparatuses 120, 400, 402. With the plurality of target sensor apparatuses 120, 400, 402, a stretch profile of the wire 150/200 may be created and monitored.

Each target sensor apparatus 120, 400, 402 comprises a barometric pressure sensor 610 configured to measure 708 a target barometric pressure. Each target sensor apparatus also comprises a wireless transceiver 618 configured to transmit 122 the target barometric pressure to the server apparatus 140.

The server apparatus 140 comprises a data communication interface 630 configured to receive 112, 122 the reference barometric pressure and the target barometric pressure.

The wireless transceivers 608, 618 operate using a standard or proprietary wireless communication protocol.

The wireless transceivers 608, 618 may utilize a cellular radio network (GSM, GPRS, EGPRS, WCDMA, UMTS, 3GPP, IMT, LTE, LTE-A, 3G, 4G, 5G etc.), and the data communication interface 630 may be configured to receive data 112, 122 transmitted via the cellular radio network from the wireless transceivers 608, 618. The data communication interface 630 may comprise a cellular radio network transceiver or an interface to a networked service via which the cellular data is received. The use of the cellular radio network may necessitate a subscriber identity module (SIM), either as a physical chip, or as an embedded-SIM (eSIM), for example. In this embodiment, a large distance, even hundreds or thousands of kilometres may separate the overhead power transmission line 190 and the server apparatus 140.

The wireless transceivers 608, 618 may also utilize a wireless local area network (such as WLAN, Wi-Fi, etc.), and the data communication interface 630 may comprise a wireless transceiver connected to the wireless local area network. In this embodiment, the distance between the overhead power transmission line 190 and the server apparatus 140 is at maximum a few kilometres.

The wireless transceivers 608, 618 may also utilize a short-range radio network (such as Bluetooth or Bluetooth Low Energy BLE, etc.), or a wireless mesh network, and the data communication interface 630 may comprise a short-range radio transceiver or a radio transceiver connected to the wireless mesh network. In this embodiment, the distance between the overhead power transmission line 190 and the server apparatus 140 is a few hundred meters.

In an embodiment illustrated in FIG. 1 and FIG. 4, the system 100 comprises a gateway apparatus 180, which is attached within a radio range from the reference sensor apparatus 110 and the one or more target sensor apparatuses 120, 400, 402. The gateway apparatus 180 relays the data transmitted between the sensor apparatuses 110, 120, 400, 402 and the server apparatus 140. In an embodiment, the gateway apparatus 180 comprises a short-range wireless transceiver 620 configured to receive the reference barometric pressure and the target barometric pressure from the sensor apparatuses 110, 120, 400, 402, and a cellular wireless transceiver 628 configured to transmit the reference barometric pressure and the target barometric pressure to the server apparatus 140.

Depending on the implementation, the gateway apparatus 180 may comprise one or more memories 624 including computer program code 626, and one or more processors 622 configured to execute the computer program code 626 to cause the gateway apparatus 180 to perform various operations of the method / algorithm 650B.

The server apparatus 140 also comprises one or more memories 634 including computer program code 636, and one or more processors 632 configured to execute the computer program code 636 to cause the server apparatus 140 to perform various operations of the method / algorithm 650A.

Depending on the implementation, the reference sensor apparatus 110 may comprise one or more memories 604 including computer program code 606, and one or more processors 602 configured to execute the computer program code 606 to cause the reference sensor apparatus 110 to perform various operations of the method / algorithm 650C.

Depending on the implementation, the one or more target sensor apparatuses 120 may each comprise one or more memories 614 including computer program code 616, and one or more processors 612 configured to execute the computer program code 616 to cause the target sensor apparatus 120 to perform various operations of the method / algorithm 650D.

The term 'processor' 602, 612, 622, 632 refers to a device that is capable of processing data. When designing the implementation of the processor 602, 612, 622, 632, a person skilled in the art will consider the requirements set for the size and power consumption of the apparatus 110, 120, 140, 180, the necessary processing capacity, production costs, and production volumes, for example.

The term 'memory' 604, 614, 624, 634 refers to a device that is capable of storing data run-time (= working memory) or permanently (= non-volatile memory). The working memory and the non-volatile memory may be implemented by a random-access memory (RAM), dynamic RAM (DRAM), static RAM (SRAM), a flash memory, a solid state disk (SSD), PROM (programmable read-only memory), a suitable semiconductor, or any other means of implementing an electrical computer memory.

A non-exhaustive list of implementation techniques for the processor 602, 612, 622, 632 and the memory 604, 614, 624, 634 includes, but is not limited to: logic components, standard integrated circuits, application-specific integrated circuits (ASIC), system-on-a-chip (SoC), application-specific standard products (ASSP), microprocessors, microcontrollers, digital signal processors, special-purpose computer chips, field-programmable gate arrays (FPGA), and other suitable electronics structures.

The computer program code 606, 616, 626, 636 may be implemented by software. In an embodiment, the software may be written by a suitable programming language, and the resulting executable code may be stored in the memory 604, 614, 624, 634 and executed by the processor 602, 612, 622, 632.

The computer program code 606, 616, 626, 636 implements the algorithm 650A, 650B, 650C, 650D for determining the sag. The computer program code 606, 616, 626, 636 may be coded as a computer program (or software) using a programming language, which may be a high-level programming language, such as C, C++, or Java, or a low-level programming language, such as a machine language, or an assembler, for example. The computer program code 606, 616, 626, 636 may be in source code form, object code form, executable file, or in some intermediate form. There are many ways to structure the computer program code 606, 616, 626, 636: the operations may be divided into modules, sub-routines, methods, classes, objects, applets, macros, etc., depending on the software design methodology and the programming language used. In modern programming environments, there are software libraries, i.e. compilations of ready-made functions, which may be utilized by the computer program code 606, 616, 626, 636 for performing a wide variety of standard operations. In addition, an operating system (such as a general-purpose operating system) may provide the computer program code 606, 616, 626, 636 with system services.

An embodiment provides a computer-readable medium 640 storing computer program code 636, which, when loaded into the one or more processors and executed by one or more processors 632, causes the one or more processors 632 to perform the part 650A of the algorithm/method. The computer-readable medium 640 may comprise at least the following: any entity or device capable of carrying the computer program code 636 to the one or more processors 632, a record medium, a computer memory, a read-only memory, an electrical carrier signal, a telecommunications signal, and a software distribution medium. In some jurisdictions, depending on the legislation and the patent practice, the computer-readable medium 640 may not be the telecommunications signal. In an embodiment, the computer-readable medium 640 may be a computer-readable storage medium. In an embodiment, the computer-readable medium 640 may be a non-transitory computer-readable storage medium.

In an embodiment, the processor 602, 612, 622, 632 may be implemented as a microprocessor implementing functions of a central processing unit (CPU) on an integrated circuit. The CPU is a logic machine executing the computer program code 606, 616, 626, 636. The CPU may comprise a set of registers, an arithmetic logic unit (ALU), and a control unit (CU). The control unit is controlled by a sequence of the computer program code 606, 616, 626, 636 transferred to the CPU from the (working) memory 604, 614, 624, 634. The control unit may contain a number of microinstructions for basic operations. The implementation of the microinstructions may vary, depending on the CPU design.

In an embodiment of the sensor apparatuses 110, 120, 400, 402, the processor 602, 612 and the one or more memories 604, 614 are implemented as a microcontroller, possibly with a full suite of program and system development tools, maybe even with software libraries and a real-time operating system.

Note that depending on the implementation and the use case, the roles of the various system actors 110, 120, 140, 180 may be combined. In the basic scenario, each of these 110, 120, 140, 180 is a separate apparatus. The server apparatus 140 may be a networked computer server, which interoperates with the reference sensor apparatus 110 and the one or more target sensor apparatuses 120 directly or via the gateway apparatus 180 according to a client-server architecture, a cloud computing architecture, a peer-to-peer system, or another applicable distributed computing architecture. In an alternative scenario, the roles of reference sensor apparatus 110 and the gateway apparatus 180 are combined into a single apparatus. In the same way, the roles of the reference sensor apparatus 110 and the server apparatus 140 may be combined into a single apparatus. In every scenario, the server apparatus 140 may comprise a user interface to interact with control/service personnel, or the server apparatus 140 may be communicatively coupled to a stationary or portable user apparatus with which the control/service personnel may interact with the system 100. The system 100 may provide also visual information regarding the sag 154, possibly in a form of stretch profile of the wire 150/200 so that the user may easily monitor the sag 154 regarding a limit defining an excessive sag.

In an embodiment, the reference sensor apparatus 110 and/or the one or more target sensor apparatuses, 120, 400, 402 comprise each an energy harvesting circuit configured to obtain electric power for operation from the wire 150. Alternatively, or additionally, the reference sensor apparatus 110 and/or the one or more target sensor apparatuses, 120, 400, 402 may each comprise one or more batteries for providing electric power for operation. The one or more batteries may be rechargeable batteries or even alkaline batteries, depending on the use case. The one or more batteries may be of a type designed to be used in a wide temperature range.

Let us now study the algorithm/method with reference to FIG. 7.

The method starts in 700 and ends in 752. Note that the method may run as long as required by looping back to an operation 702 or 704.

The operations are not strictly in chronological order in FIG. 7, and some of the operations may be performed simultaneously or in an order differing from the given ones. For example, operations 702, 704, 706, 708, 710, 712, 714, 716, 718, 720 may be executed in a different order but before an operation 722. Other functions may also be executed between the operations or within the operations and other data exchanged between the operations. Some of the operations or part of the operations may also be left out or replaced by a corresponding operation or part of the operation. It should be noted that no special order of operations is required, except where necessary due to the logical requirements for the processing order.

In 704, the reference barometric pressure is measured by the reference sensor apparatus 110.

In 708, the target barometric pressure is measured by the target sensor apparatus 120, 400, 402.

In 722, the server apparatus 140 is caused to determine the sag 154 of the wire 150/200 based on the reference barometric pressure and the target barometric pressure.

In an embodiment, the server apparatus 140 is caused to determine 722 the sag 154 by processing 730 a difference between the reference barometric pressure and the target barometric pressure as a vertical height difference. For example, a barometric pressure difference of one pascal (Pa) translates to eight centimetres in a vertical height. The ambient temperature of the measurement environment has an effect on this ratio, but as it may be assumed that the ambient temperature is the same in the vicinity of both the reference sensor apparatus 110 and the one or more target sensor apparatuses 120, 400, 402, the effect of the ambient temperature maybe excluded.

In an embodiment, the server apparatus 140 is caused to determine 748 a normal sag during a season with no snow or ice, and monitor 750 the sag 154 during a season with snow or ice. With this embodiment, the normal sag without the influence of snow or ice may be determined during late spring, summer, or early autumn. As the wire 150/200 becomes loaded with snow and/or ice during the winter, the sag 154 may be monitored and an increase in the sag 154 may be detected early enough so that a damage to the wire 150/200 may be prohibited by the service personnel. An excessive sag 154 may damage the wire 150/200 permanently, and in some case cause a blackout. For example, if the lightning arrester steel wire 200 stretches excessively, it may contact the power line 150 beneath, whereby an earth fault current may cause a power off in the overhead power transmission line 190.

In an embodiment, the server apparatus 140 is caused to determine 748 a normal sag during a predetermined low ambient temperature, and monitor 750 the sag 154 during a predetermined high ambient temperature, wherein the predetermined high ambient temperature is higher than the predetermined low ambient temperature. With this embodiment, the damage to the wire 150/200 may be prohibited during the summer or a heatwave by detecting an increase in the sag 154 as compared to the normal sag in a normal low temperature.

In an embodiment illustrated in FIG. 1 and FIG. 4, the system 100 comprises an additional reference sensor apparatus 130, which is attached in a location with a known vertical distance in relation to a clamp 172/404 coupling the wire 150/200 with the other support 170 of the two adjacent supports 160, 170. The additional reference sensor apparatus 130 comprises the barometric pressure sensor 600 configured to measure 706 an additional reference barometric pressure, and the wireless transceiver 608 configured to transmit the additional reference barometric pressure. The data communication interface 630 of the server apparatus 140 is configured to receive the additional reference barometric pressure. The server apparatus 140 is caused to determine the sag 154 also based on 732 the additional reference barometric pressure.

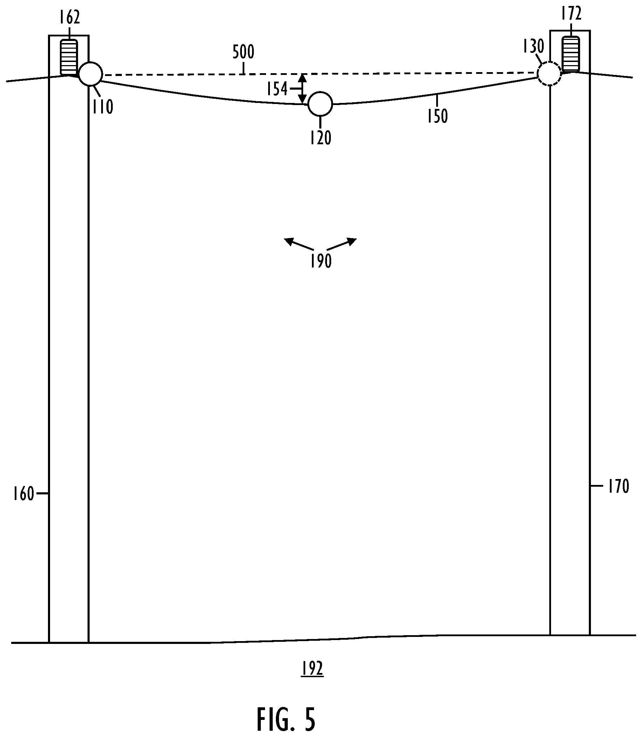

In an embodiment, illustrated in FIG. 5, the server apparatus 140 is caused to determine 710 a virtual height line 500 between the clamp 162 coupling the wire 150 with the one support 160 of the two adjacent supports 160, 170 and a clamp 172 coupling the wire 150 with the other support 170 of the two adjacent supports 160, 170, and to determine 722 the sag 154 also based on 734 the virtual virtual height line 500.

In an embodiment, the server apparatus 140 is caused to compare 724 the sag 154 to a predetermined threshold value, and if the sag 154 exceeds the predetermined threshold value 724-YES, to raise 726 an alarm. The alarm may be notified to the control/service personnel via a user interface coupled with the server apparatus 140.

Let us finally study various embodiments, which may additionally enhance the operation of the system 100.

In an embodiment, the reference sensor apparatus 110 and/or each of the one or more target sensor apparatuses 120, 400, 402 comprises a positioning receiver (using GPS, Galileo or another applicable global navigation satellite system) 664 configured to determine a geographical position, which is coupled with the transmitted reference barometric pressure and the transmitted target barometric pressure. Alternatively, or additionally, the gateway apparatus 180 may comprise a positioning receiver, or the gateway apparatus 180 may obtain location data using cellular radio system -based positioning.

In an embodiment, the reference sensor apparatus 110 and/or each of the one or more target sensor apparatuses 120, 400, 402 comprises a memory 604, 614 configured to store a unique identifier inputted during an installation and related to a geographical position, which is coupled with the transmitted reference barometric pressure and the transmitted target barometric pressure.

In an embodiment, the reference sensor apparatus 110 and/or each of the one or more target sensor apparatuses 120, 400, 402 comprises an accelerometer 666 configured to measure 712 a motion of the wire 150/200, which is transmitted to the server apparatus 140, and the server apparatus 140 is caused to analyze 736 the sag 154 in view of the motion. The motion may indicate a large motion of the wire 150/200 caused by the wind, or a vibration caused by the electric power. The accelerometer 666 may measure the vibration in one to three dimensions, for example. Additionally, the accelerometer 666 may belong to an inertial measurement unit, which, besides the accelerometer 666, may also comprise a gyroscope and a magnetometer, whereby up to 9 different axes may be measured.

In an embodiment, the reference sensor apparatus 110 and/or each of the one or more target sensor apparatuses 120, 400, 402 comprises a relative humidity sensor 668 configured to measure 714 an ambient relative humidity, which is transmitted to the server apparatus 140, and the server apparatus 140 is caused to analyze 738 the sag 154 in view of the ambient relative humidity.

In an embodiment, the reference sensor apparatus 110 and/or each of the one or more target sensor apparatuses 120, 400, 402 comprises an ambient temperature sensor 670 configured to measure 702 an ambient temperature, which is transmitted to the server apparatus 140, and the server apparatus 140 is caused to analyze 740 the sag 154 in view of the ambient temperature. For example, it may be assessed whether the sag 154 is within a normal tolerance taking into account the ambient temperature.

In an embodiment, the reference sensor apparatus 110 and/or each of the one or more target sensor apparatuses 120, 400, 402 comprises a directed temperature sensor 672 configured to measure 716 a temperature of the wire 150/200, which is transmitted to the server apparatus 140, and the server apparatus 140 is caused to analyze 742 the sag 154 in view of the temperature of the wire 150/200. In some cases, the temperature of the wire 150/200 may give an indication of the circumstances causing the sag 154 to increase. For example, a fault situation may be detected by the server if the temperature of the power line 200 is higher than a normal operating temperature.

In an embodiment, the reference sensor apparatus 110 and/or each of the one or more target sensor apparatuses 120, 400, 402 comprises an ambient temperature sensor 670 configured to measure 702 an ambient temperature, and the reference sensor apparatus 110 and the one or more target sensor apparatuses 120, 400, 402 are configured to adjust 728 the measurement 704, 708 and transmission to be made more often if the ambient temperature exceeds a first predetermined threshold value in a warm climate, or more often if the ambient temperature is below a second threshold value in a cold climate. In this way, the operation time of the reference sensor apparatus 110 and the one or more target sensor apparatuses 120 may be improved.

In an embodiment, the reference sensor apparatus 110 and/or each of the one or more target sensor apparatuses 120, 400, 402 comprises a voltage detector 674 configured to detect 718 a live status of the wire 200, which is transmitted to the server apparatus 140, and the server apparatus 140 is caused to analyze 744 the sag 154 in view of the live status.

In an embodiment, the reference sensor apparatus 110 and/or each of the one or more target sensor apparatuses 120, 400, 402 comprises a current measuring circuit 676 configured to measure 720 a current level from the wire 200, which is transmitted to the server apparatus 140, and the server apparatus 140 is caused to analyze 746 the sag 154 in view of the current level. In a three-phase electric power overhead transmission line 190, each power line 150A, 150B, 150C may be measured by an own current measuring circuit 676, so that possible faults (like a transformer fault) may be detected in the server apparatus 140.

The live status and the current level may indicate a fault condition of the wire 150/200 or an excessive amount of electric energy in the wire 150/200, which may offer a further insight to the sag 154.

Even though the invention has been described with reference to one or more embodiments according to the accompanying drawings, it is clear that the invention is not restricted thereto but can be modified in several ways within the scope of the appended claims. All words and expressions should be interpreted broadly, and they are intended to illustrate, not to restrict, the embodiments. It will be obvious to a person skilled in the art that, as technology advances, the inventive concept can be implemented in various ways.

## Claims

1. A system (100) for determining a sag (154) of a wire (150; 200) in an overhead power transmission line (190) between two adjacent supports (160, 170), comprising:
a reference sensor apparatus (110), attached in a location with a known vertical distance in relation to a clamp (162; 202) coupling the wire (150; 200) with one support (160) of the two adjacent supports (160, 170), and comprising a barometric pressure sensor (600) configured to measure (704) a reference barometric pressure, and a wireless transceiver (608) configured to transmit the reference barometric pressure;
one or more target sensor apparatuses (120, 400, 402), attached to the wire (150; 200) between the two adjacent supports (160, 170), and comprising a barometric pressure sensor (610) configured to measure (708) a target barometric pressure, and a wireless transceiver (618) configured to transmit the target barometric pressure; and
a server apparatus (140), comprising a data communication interface (630) configured to receive the reference barometric pressure and the target barometric pressure, one or more memories (634) including computer program code (636), and one or more processors (632) configured to execute the computer program code (636) to cause the server apparatus (140) to determine (722) the sag (154) of the wire (150; 200) based on the reference barometric pressure and the target barometric pressure.

2. The system of claim 1, wherein the reference sensor apparatus (110) is attached to the wire (150; 200) next to the clamp (162; 202) or to the one support (160) next to the clamp (162; 202).

3. The system of any preceding claim, wherein the wire (150; 200) comprises a lightning arrester steel wire (200) and/or a power line (150), and the reference sensor apparatus (110) and/or the one or more target sensor apparatuses (120, 400, 402) are configured to be attached to the lightning arrester steel wire (200) and/or to the power line (150).

4. The system of any preceding claim, wherein the one or more target sensor apparatuses (120, 400, 402) comprise a single target sensor apparatus (120) attached to a middle point in the wire (150, 200) between the two adjacent supports (160, 170) and/or a plurality of target sensor apparatuses (120, 400, 402) attached to known points in the wire (150, 200) between the two adjacent supports (160, 170).

5. The system of any preceding claim, wherein the one or more target sensor apparatuses (120, 400, 402) are encapsulated in one or more bird balls configured to warn birds of the overhead power transmission line (190).

6. The system of any preceding claim, wherein the two adjacent supports (160, 170) comprise a wooden pole, a metal pole, a reinforced concrete pole, a lattice metal tower.

7. The system of any preceding claim, wherein the server apparatus (140) is caused to determine (722) the sag (154) by processing (730) a difference between the reference barometric pressure and the target barometric pressure as a vertical height difference.

8. The system of any preceding claim, wherein the server apparatus (140) is caused to determine (748) a normal sag during a season with no snow or ice, and monitor (750) the sag (154) during a season with snow or ice.

9. The system of any preceding claim, wherein the server apparatus (140) is caused to determine (748) a normal sag during a predetermined low ambient temperature, and monitor (750) the sag (154) during a predetermined high ambient temperature, wherein the predetermined high ambient temperature is higher than the predetermined low ambient temperature.

10. The system of any preceding claim, wherein the system (100) comprises an additional reference sensor apparatus (130), attached in a location with a known vertical distance in relation to a clamp (172; 404) coupling the wire (150; 200) with the other support (170) of the two adjacent supports (160, 170), and comprising a barometric pressure sensor configured to measure (706) an additional reference barometric pressure, and a wireless transceiver configured to transmit the additional reference barometric pressure, and the data communication interface (630) of the server apparatus (140) is configured to receive the additional reference barometric pressure, and the server apparatus (140) is caused to determine the sag (154) also based on (732) the additional reference barometric pressure.

11. The system of any preceding claim, wherein the server apparatus (140) is caused to determine (710) a virtual height line (500) between the clamp (162) coupling the wire (150) with the one support (160) of the two adjacent supports (160, 170) and a clamp (172) coupling the wire (150) with the other support (170) of the two adjacent supports (160, 170), and to determine (722) the sag (154) also based on (734) the virtual virtual height line (500).

12. The system of any preceding claim, wherein the server apparatus (140) is caused to compare (724) the sag (154) to a predetermined threshold value, and if the sag (154) exceeds the predetermined threshold value (724-YES), to raise (726) an alarm.

13. The system of any preceding claim, the system (100) comprising a gateway apparatus (180), attached within a radio range from the reference sensor apparatus (110) and the one or more target sensor apparatuses (120, 400, 402), and comprising a short-range wireless transceiver (620) configured to receive the reference barometric pressure and the target barometric pressure, and a cellular wireless transceiver (628) configured to transmit the reference barometric pressure and the target barometric pressure.

14. The system of any preceding claim, wherein the system (100) comprises within the reference sensor apparatus (110) and/or within the one or more target sensor apparatuses (120, 400, 402) one or more of the following:
a positioning receiver (664) configured to determine a geographical position, which is coupled with the transmitted reference barometric pressure and the transmitted target barometric pressure;
a memory (604, 614) configured to store a unique identifier inputted during an installation and related to a geographical position, which is coupled with the transmitted reference barometric pressure and the transmitted target barometric pressure;
an accelerometer (666) configured to measure (712) a motion of the wire (150; 200), which is transmitted to the server apparatus (140), and the server apparatus (140) is caused to analyze (736) the sag (154) in view of the motion;
a relative humidity sensor (668) configured to measure (714) an ambient relative humidity, which is transmitted to the server apparatus (140), and the server apparatus (140) is caused to analyze (738) the sag (154) in view of the ambient relative humidity;
an ambient temperature sensor (670) configured to measure (702) an ambient temperature, which is transmitted to the server apparatus (140), and the server apparatus (140) is caused to analyze (740) the sag (154) in view of the ambient temperature;
a directed temperature sensor (672) configured to measure (716) a temperature of the wire (150; 200), which is transmitted to the server apparatus (140), and the server apparatus (140) is caused to analyze (742) the sag (154) in view of the temperature of the wire (150; 200);
an ambient temperature sensor (670) configured to measure (702) an ambient temperature, and the reference sensor apparatus (110) and the one or more target sensor apparatuses (120, 400, 402) are configured to adjust (728) the measurement (704, 708) and transmission to be made more often if the ambient temperature exceeds a first predetermined threshold value in a warm climate, or more often if the ambient temperature is below a second threshold value in a cold climate;
a voltage detector (674) configured to detect (718) a live status of the wire (200), which is transmitted to the server apparatus (140), and the server apparatus (140) is caused to analyze (744) the sag (154) in view of the live status;
a current measuring circuit (676) configured to measure (720) a current level from the wire (200), which is transmitted to the server apparatus (140), and the server apparatus (140) is caused to analyze (746) the sag (154) in view of the current level.

15. A method for determining a sag of a wire in an overhead power transmission line between two adjacent supports, comprising:
measuring (704) a reference barometric pressure;
measuring (708) a target barometric pressure; and
determining (722) the sag of the wire based on the reference barometric pressure and the target barometric pressure.
